**Europäisches Patentamt**

**European Patent Office**

**Office européen des brevets**

(11) Publication number: **0 194 051**
**B1**

(12) **EUROPEAN PATENT SPECIFICATION**

(45) Date of publication of patent specification: **18.04.90**

(51) Int. Cl.⁵: **C 30 B 15/30**

(21) Application number: **86300926.2**

(22) Date of filing: **11.02.86**

(54) Method for manufacturing single crystal.

(30) Priority: **14.02.85 JP 26742/85**
**28.03.85 JP 64467/85**

(43) Date of publication of application:
**10.09.86 Bulletin 86/37**

(45) Publication of the grant of the patent:
**18.04.90 Bulletin 90/16**

(84) Designated Contracting States:
**DE FR GB**

(56) References cited:
**GB-A-2 136 310**

**JOURNAL OF THE ELECTROCHEMICAL SOCIETY, vol. 129, no. 2, 1982, pages 427-429; K.M. KIM: "Suppression of thermal convection by transverse magnetic field"**

**JAPANESE JOURNAL OF APPLIED PHYSICS, vol. 23, no. 8, part 2, August 1984, pages L527-L530, Tokyo, JP; H. HIRATA et al.: "Study of thermal symmetry in czochralski silicon melt under a vertical magnetic field"**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Terashima, Kazutaka c/o Patent Division**
**Kabushiki Kaisha Toshiba 1-1 Shibaura 1-chome Minato-ku Tokyo 105 (JP)**
Inventor: **Washizuka, Syoichi c/o Patent Division**
**Kabushiki Kaisha Toshiba 1-1 Shibaura 1-chome Minato-ku Tokyo 105 (JP)**
Inventor: **Watanabe, Masayuki c/o Patent Division**
**Kabushiki Kaisha Toshiba 1-1 Shibaura 1-chome Minato-ku Tokyo 105 (JP)**
Inventor: **Nishio, Johji c/o Patent Division**
**Kabushiki Kaisha Toshiba 1-1 Shibaura 1-chome Minato-ku Tokyo 105 (JP)**
Inventor: **Yoshiro, Sadao c/o Patent Division**
**Kabushiki Kaisha Toshiba 1-1 Shibaura 1-chome Minato-ku Tokyo 105 (JP)**
Inventor: **Kojima, Masakatu c/o Patent Division**
**Kabushiki Kaisha Toshiba 1-1 Shibaura 1-chome Minato-ku Tokyo 105 (JP)**

(74) Representative: **Freed, Arthur Woolf et al**
**MARKS & CLERK 57-60 Lincoln's Inn Fields London WC2A 3LS (GB)**

Courier Press, Leamington Spa, England.

## Description

The present invention relates to a method of manufacturing a single crystal and, more particularly, to a method and apparatus for manufacturing a semiconductive single crystal from a melt of a conductive material using a crystal pulling method while applying a horizontal magnetic field to the melt.

In the crystal pulling method, a semiconductive seed crystal (of course, a single crystal) is dipped in a melt or saturated solution until it is well wetted, and is then gradually pulled out, thus growing a single crystal in an ingot form at the distal end of a pulling shaft. This method is also known as the Czochralski" method, and with it, a high-quality single crystal can be obtained. Since a single crystal to be grown is not placed in direct contact with an inner wall of an envelope (a crucible) carrying the melt, purity of the single crystal manufactured is improved, and crystal dislocation can be suppressed. Modern semiconductor industries use these advantages of the pulling method to form single crystal ingots. An ingot so formed is sliced into single crystal wafers (from each of which chip substrates for integrated circuits are prepared).

However, higher integration of recent semiconductor IC devices exerts higher requirements on the crystallinity of a single crystal formed by the pulling method. With this trend, since the element size of respective devices is considerably reduced, a small crystal defect included in a single crystal wafer, which was negligible in a conventional wafer, often degrades the manufacturing yield of chip substrates. Therefore, a great demand has arisen for effectively suppressing crystal defects included in single crystals and achieving higher uniformity thereof.

A method for improving uniformity of a single crystal grown using the pulling method is known wherein a horizontal magnetic field is applied to a conductive melt from which a single crystal is being grown. During single crystal growth, when a horizontal magnetic field is applied to the melt, heat convection generated in the melt in its envelope (i.e., crucible) can be suppressed or prevented. Therefore, since an interface between the melt and the growing single crystal can be kept stable, the crystallinity of the single crystal produced can be improved.

With this method, however, a magnetic field which can effectively suppress heat convection in the melt falls in a narrow range (i.e., 1,200 Oe± several tens of Oe). An example of this type of method is given in GB Patent Application No. 2136310. Therefore, the strength of the magnetic field to be applied to the melt during single crystal growth must be precisely controlled, so as to fall within that narrow range. It is, however, very difficult to maintain the magnetic field strength at a target level within the narrow range. If the strength of the magnetic field falls even slightly out of the narrow range, the effect of suppressing heat convection in the melt is immediately degraded. As a result, although this method has been appreciated logically, the practical effect (i.e., obtaining an improved single crystal with highly controlled crystallinity) cannot be expected.

It is therefore an object of the present invention to provide a new and improved method of manufacturing a single crystal which can effectively improve uniformity of the single crystal.

According to a technique of the present invention, a seed crystal is brought into contact with a melt comprising a semiconductive material in an envelope, placed in an atmosphere which satisfies given conditions, and is then pulled out so as to grow a single crystal. During crystal growth, a horizontal magnetic field is applied to the melt. The horizontal magnetic field is set high enough to obtain a specific strength level. When the whole region of the magnetic field strength actually applied to the melt is divided into first to fourth regions in accordance with change in temperature fluctuation occurring in the melt, the specific strength level is set so as to be included in the highest, fourth region. The temperature fluctuation in the melt increases and varies with respect to the strength of the magnetic field in such a manner that it is increased in the first region representing the lowest strength region, suppressed in the second region, increased again in the third region, and suppressed again in the fourth region. It was demonstrated in a test by the present inventors that the specific strength level range of the horizontal magnetic field is over 3,000 Oe for a III—V group compound semiconductor such as GaAs. In this way, when the magnetic field strength applied to the melt is set within a specific range, temperature fluctuation in the melt can be suppressed or substantially prevented, thus effectively improving uniformity of a single crystal.

When the specific magnetic field is applied to the melt in accordance with the above concept, a heater arranged in the envelope for heating the melt is driven not by AC voltage but by DC voltage. When the heater is driven by DC voltage, mechanical vibration of the heater during the heating process can be reduced significantly. Therefore, impurities (e.g., carbon particles or gas) can be prevented from being undesirably dispersed into the melt from the heater because of its vibration. This greatly contributes to the improvement in the crystallinity of a single crystal. The other features and technical advantages of the present invention will be apparent from the following detailed description.

Embodiments of the present invention will be best understood by reference to the accompanying drawings, in which:

Fig. 1A is a graph representing the results of measurement of heat convection characteristics in a melt in order to indicate the range of a magnetic field strength to be applied to the melt while a single crystal is grown by the pulling method;

Fig. 1B is a graph, based on the results of Fig.

1A, showing a change in temperature fluctuation against the magnetic field strength in the melt;

Fig. 2 is a schematic block diagram showing an apparatus for manufacturing a single crystal according to one preferred embodiment of the present invention;

Fig. 3 is a diagram showing an arrangement of a DC power supply which drives a heater for heating a melt in a crucible;

Figs. 4A and 4B are microphotographs comparing crystallinities of single crystals formed by a conventional method and the pulling method of the present invention; and

Figs. 5 to 12 are graphs showing the results of tests conducted to demonstrate various improved characteristics of the single crystal produced by the pulling method of the present invention.

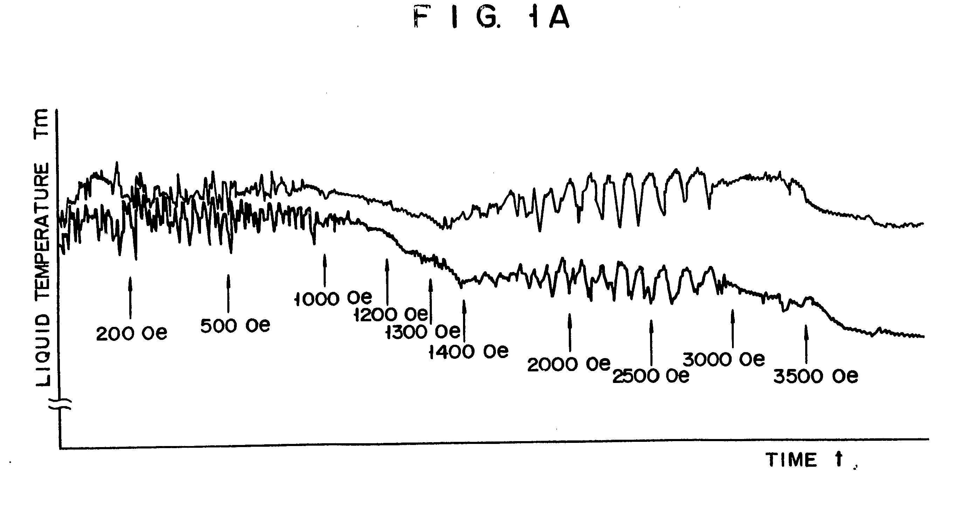

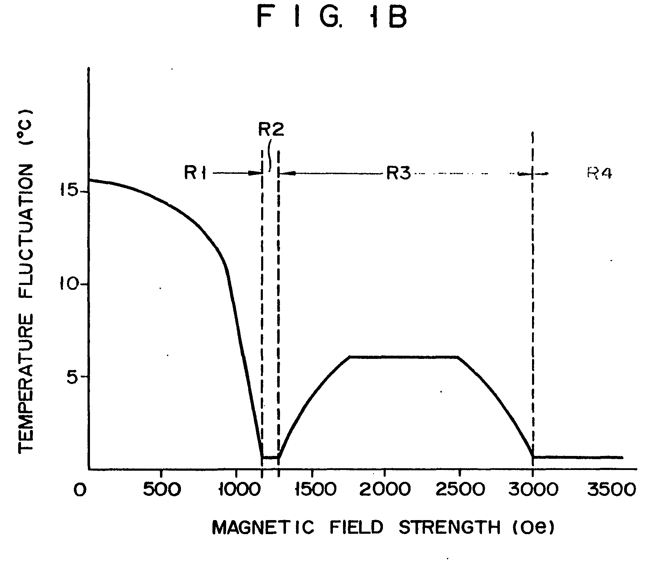

A pulling method of an embodiment of the present invention comprises a horizontal magnetic field strength being applied to a melt of a material in an envelope (crucible) during single crystal growth and set within a specific range, higher than that in a conventional method. Prior to a description of the specific magnetic field range setting, temperature fluctuation characteristics will be described with reference to the graph shown in Fig. 1A, which was demonstrated by the present inventors and which represents temperature fluctuation occurring in a melt in accordance with a change in a horizontal magnetic field strength applied thereto.

The present inventors measured temperature fluctuation occurring in the melt over a wide range of horizontal magnetic field strengths higher than the conventional range. As a result, the present inventors found that temperature fluctuation in the melt can be minimized when the magnetic field strength exceeds a specific level. Fig. 1A shows a change in temperature in the melt, and Fig. 1B shows the relationship between the magnetic field strength applied and temperature fluctuation in the melt.

The present inventors selected a melt of gallium arsenide (GaAs) as a compound semiconductor. In order to grow a single crystal according to the pulling method, the horizontal magnetic field applied to the GaAs melt in the crucible was varied over a wide range, including at least a range of 3,000 Oersteds (conventionally referred to as "Oe" hereinafter) or higher, and the change in temperature Tm in central and peripheral surface portions of the melt was measured. In Fig. 1A, a bold curve indicates the change in temperature at the central surface portion of the melt in the crucible, and a normal curve indicates a change in temperature at the peripheral surface portion thereof. To perform this temperature measurement, temperature sensors comprising known thermocouples covered with quartz tubes were used. For the measurement, the peripheral surface portion was separated from the central surface portion by 35 mm. As is well known, a liquified protection layer (to be referred as a "liquid encapsulant" hereinafter) is placed on the GaAs melt. The temperature sensors were arranged in the previously mentioned measurement positions in the GaAs melt surface through the liquid encapsulant.

In the graph of Fig. 1A, values of the magnetic field strength increased over time t are indicated by arrows. Both the characteristic curves varied widely until the horizontal magnetic field strength applied to the GaAs melt reached about 1,100 Oe. This means that temperature fluctuation occurred in the melt during heating. This range is indicated by R1 in Fig. 1B. As has been mentioned previously, if the magnetic field strength is set within this range (to be referred to as "first range R1" hereinafter), crystallinity of the single crystal pulled is degraded due to the temperature fluctuation in the melt.

When the magnetic field strength reached 1,200 Oe, temperature fluctuation in the GaAs melt was suppressed. A magnetic field strength range of 1,100 Oe to 1,300 Oe will be referred to as "second range R2" hereinafter. When the magnetic field strength exceeded 1,300 Oe, temperature fluctuation in the GaAs melt again increased, as shown in Fig. 1B. A re-increase in temperature fluctuation is also apparent from Fig. 1A, in which both the curves begin to vary widely again. In the conventional method, the horizontal magnetic field strength is controlled to fall in second range R2 and, more specifically, the single crystal is typically pulled at the magnetic field strength of 1,200 Oe.

The present inventors continued observation of temperature fluctuation upon increase in magnetic field strength. As a result, it was found that temperature fluctuation began to decrease again when the magnetic field strength applied exceeded 2,500 Oe, and that it could be suppressed satisfactorily when the field strength exceeded 3,000 Oe, as shown in Fig. 1B. In other words, it was observed that temperature fluctuation in the GaAs melt can be suppressed or prevented when the magnetic field strength exceeds third range R3 and falls in fourth range R4 (higher than 3,000 Oe—Fig. 1A). (In this case, however, it is impossible to generate an extremely high magnetic field strength with current electromagnetic techniques, and a maximum strength level may be limited corresponding to the performance of currently designed magnets). Furthermore, temperature fluctuations in fourth range R4 were even smaller than those in second range R2, and it should be noted that fourth range R4 is much wider than range R2. This means that temperature fluctuation in the melt can be effectively minimized when the magnetic field strength applied to the GaAs melt is set to be higher than 3,000 Oe.

Therefore, when a semiconductor single crystal is produced in accordance with the pulling method of the present invention, the horizontal magnetic field having a strength of 3,000 Oe or higher (e.g., 3,400 to 3,500 Oe or higher) is applied to the melt in the crucible. In doing so, temperature fluctuation in the melt can be minimized, and a uniform single crystal with small crystal defect density (e.g., dislocation) and excellent crystallinity can be produced.

In this case, since fourth range R4 of the present invention is much wider than second range R2 used in the conventional method, even if the magnetic field strength varies slightly due to adverse influences of, e.g., ambient conditions, temperature fluctuation in the melt is still significantly suppressed. Therefore, when a semiconductive single crystal is actually produced using the concept of the present invention, even if an automatic control system for controlling a magnetic field is omitted, a single crystal of satisfactory quality can be obtained.

In addition, although a change in liquid temperature Tm was measured up to a magnetic field strength of over 4,000 Oe, depending on the maximum level of the magnet used, as shown in Fig. 1A, it was confirmed that the effect of suppressing temperature fluctuation was not degraded even when the magnetic field strength exceeded 10,000 Oe.

The above test was conducted using the compound semiconductor (GaAs). However, if other monocrystalline semiconductive materials (e.g., silicon) are used, fourth range R4 appears similarly (even though an actual magnetic field strength range differs from that of the GaAs melt). Therefore, when a silicon single crystal is produced, the horizontal magnetic field strength applied to the Si melt can be controlled to be higher than a lower limit value of fourth range R4 unique to the Si melt. Thus, the concept of the present invention can be applied to the manufacture of other single crystals.

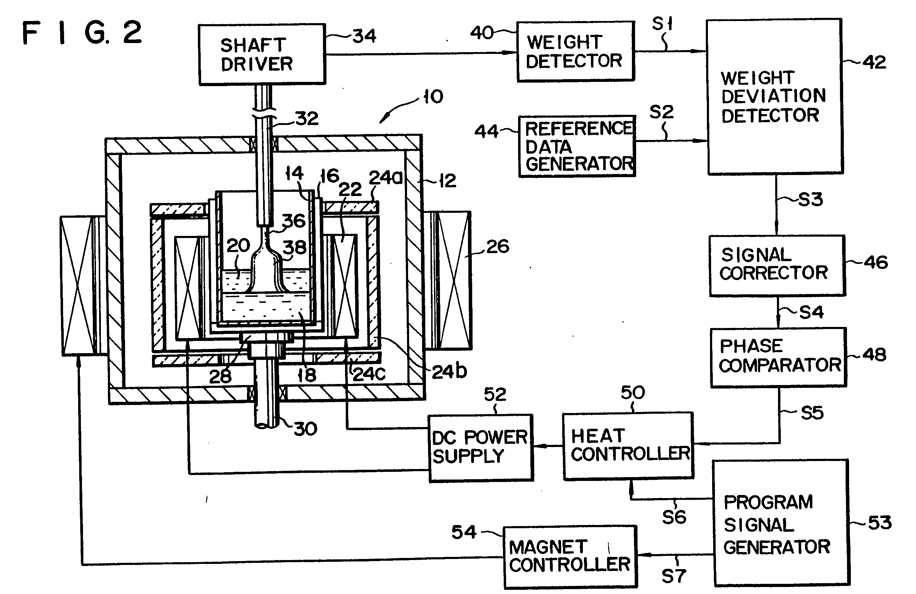

Fig. 2 schematically illustrates an apparatus for manufacturing a single crystal of a compound semiconductor (e.g., GaAs) according to one preferred embodiment of the present invention. This apparatus is suited for the manufacture of a single crystal of a III—V compound semiconductor having a high decomposition pressure at its melting point (e.g. gallium arsenide, gallium phosphorus, indium phosphorus, or the like) using a liquid-seal high-pressure pulling method (also known as a liquid encapsulated Czochralski or LEC method). Single crystal pulling unit 10 comprises high pressure housing 12 of stainless steel. Crucible 14 and crucible receptacle 16 are arranged in housing 12. Crucible 14 is made of, e.g. pirolitic bolon nitride (PBN), and is formed in a cylindrical shape. Receptacle 16 is placed in tight contact with crucible 14 to support it stably. Metal melt 18 of metals Ga and As is housed in crucible 14. Liquid encapsulant 20 is placed on melt 18. Encapsulant 20 comprises, for example, $B_2O_3$.

In housing 12, heater 22 is arranged to surround receptacle 16 in a known manner. Heater 22 is arranged coaxially with crucible 14 and receptacle 16, and heats metals Ga and As and an encapsulant material placed in crucible 14 to obtain melt 18 and liquid encapsulant 20, which are vertically separated. Heater 22 is packed with heat shielding members 24a, 24b, and 24c, thus effectively using heat from heater 22 to keep melt 18 at a given temperature. Electromagnet 26 is arranged outside housing 12 so as to apply a horizontal magnetic field to melt 18. In this embodiment, a superconductive coil is used as electromagnet 26 to stably generate a strong horizontal magnetic field of high magnetic field strength.

Receptacle 16 is placed with its base portion on disk-like base 28, which is coupled to rotating shaft 30. Shaft 30 rotates base 28, which in turn rotates crucible 14. It should be noted that receptacle 16 and base 28 are formed of an aluminum nitride (AlN) sintered body unlike conventional ones using carbon. More specifically, a mixture of an AlN compressed powder and $Y_2O_3$ acting as a binder is sintered at a temperature of 1,800°C, thus forming receptacle 16 and base 28. Heat shielding members 24a to 24c are similarly formed of an AlN sintered body.

Pulling shaft 32 is arranged immediately above the opening of crucible 14, and is driven by shaft driver 34 so as to move vertically while being rotated. Seed crystal 36 is attached to the distal end of shaft 32, which is moved downward so that its distal end touches the upper surface of melt 18. When shaft 32 is pulled out at an appropriate speed while being rotated, ingot-like GaAs single crystal 38 can be obtained, as shown in Fig. 2.

Weight detector 40 detects a weight of pulling shaft 32 which carries growing GaAs single crystal 38 at its distal end. Detector 40 generates detection signal S1, which is supplied to weight deviation detector 42. Detector 42 is connected to reference data generator 44, which supplies to detector 42 reference weight signal S2 corresponding to a reference weight of single crystal 38. Detector 42 calculates a weight deviation between the actual weight of single crystal 38 and the reference weight, thus producing weight deviation signal S3.

Signal S3 is supplied to signal corrector unit 46. Unit 46 is constituted by first and second differentiators, and a buoyancy correction signal generator (not shown) in a known manner. Signal S3 is differentiated by the first differentiator, thus producing a differentiation output signal. The output signal is compared with a buoyancy correction signal (i.e., a signal for compensating for the buoyancy of liquid encapsulant 20) generated from the signal generator, and the effects of the buoyancy of liquid encapsulant 20 on GaAs crystal 38 are suitably corrected. A correction output signal representing a diameter fluctuation of single crystal 38 is then differentiated by the second differentiator. The differentiated result from the second differentiator is added to the output signal corrected to compensate for the buoyancy, and is generated as signal S4.

Output signal S4 from unit 46 is supplied to phase comparator 48. Comparator 48 produces phase-compensated signal S5 as a heat control signal. Signal S5 shortens the response time of melt 18 so that the heating temperature can catch up with the fluctuations in the diameter of single crystal 38. Signal S5 is supplied to heat controller 50 connected to DC power supply 52. At the same time, heating temperature program signal S6 is supplied from program signal generator 52 to heat controller 50. Controller 50 controls the DC power supply voltage from DC power supply 52 in response to signals S5 and S6. In this way, since the DC drive voltage supplied to heater 22 surrounding crucible 14 is adjusted in accordance with ambient conditions, the temperature of melt 18 can be controlled appropriately.

Magnet controller 54 is connected to superconductive electromagnet 26. Program signal generator 52 supplies magnetic field strength control signal S7 to magnet controller 54 in accordance with a given program. Controller 54 drives electromagnet 26 in response to signal S7. Thus, the strength of the horizontal magnetic field, which is generated by electromagnet 26 and applied to melt 18, can be controlled to stably fall within a range over at least 3,000 Oe in accordance with the concept of the present invention. In other words, with the apparatus of this embodiment, controller 54 drives electromagnet 26 so that the strength of the magnetic field falls in fourth range R4 (Figs. 1A and 1B) with reference to 3,500 Oe as a target strength level, for example.

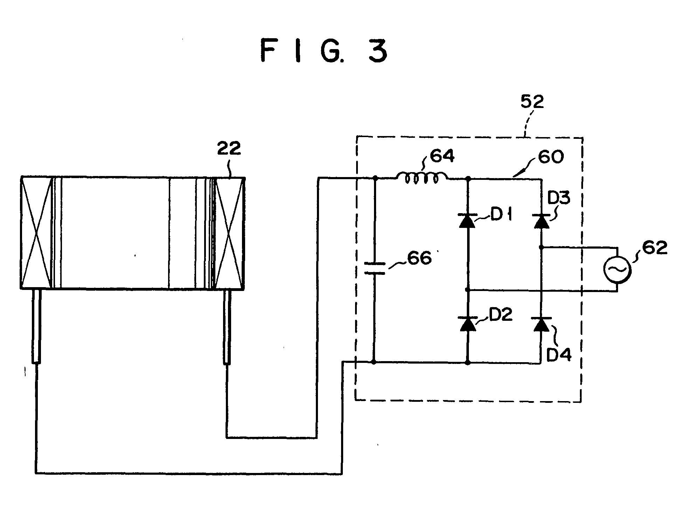

Fig. 3 shows an internal arrangement of DC power supply 52 for heater 22. DC power supply 52 comprises bridge circuit 60 for rectifying AC power source 62 (e.g., AC 100 volts), smoothing reactor (coil) 64 for smoothing the rectified current (i.e., the DC current), and smoothing capacitor 66. As is well known, bridge circuit 60 includes four diodes D1 to D4. A reactance of reactor 64 is set, for example, at 5 mH, and a capacitance of capacitor 66 is set at 2,000 µF.

A single crystal of a GaAs compound semiconductor was produced using the above-mentioned apparatus. To do so, 3 kg of Ga and As as a GaAs material were charged into crucible 14 to obtain a molecular ratio of 1:1, and a $B_2O_3$ encapsulant material was then charged therein. Ar gas was introduced into housing 12, and was compressed to 70 atm. Crucible 14 was heated by heater 22 so as to melt the materials therein, and so that liquid encapsulant 20 was on top of melt 18. The internal pressure of housing 12 was then reduced to 20 atm. A horizontal magnetic field was applied to melt 18 by electromagnet 26 so as to obtain the magnetic field strength of 3,500 Oe. More specifically, the magnetic field strength was controlled to fall in fourth range R4, in which temperature fluctuation in the melt could be minimized.

The temperature of melt 18 was thus adjusted to the optimum seeding temperature, and seed crystal 36 was placed into contact with melt 18 through liquid encapsulant 20. After seed crystal 36 had been well wetted with melt 18, 2.7 Kg of GaAs single crystal 38 was pulled out at a pulling speed of 9 mm/hr, a pulling rotational speed of 10 rpm, and a crucible rotational speed of 15 rpm.

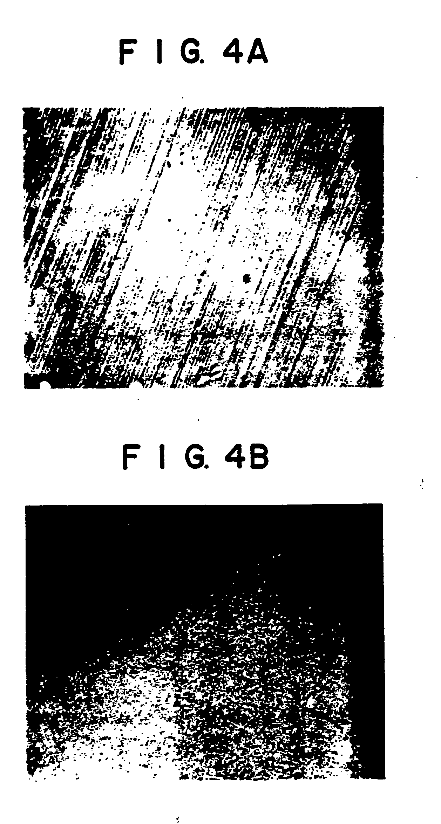

Wafers were then prepared from the thus produced GaAs single crystal 38, and were subjected to growth pattern observation using an oxide mixture of $H_2SO_4$, $H_2O_2$ and $H_2O$ (15:1:1). As a result, good crystallinity, shown in Fig. 4B, was obtained. Note that Fig. 4B is a microphotograph showing a surface condition of the wafer prepared in accordance with the method of the present invention, and Fig. 4A is a microphotograph when no magnetic field is applied during the manufacture of a single crystal according to the conventional method. These microphotographs reveal that the single crystal obtained in the method of the present invention has high uniformity when compared with one obtained in the conventional method.

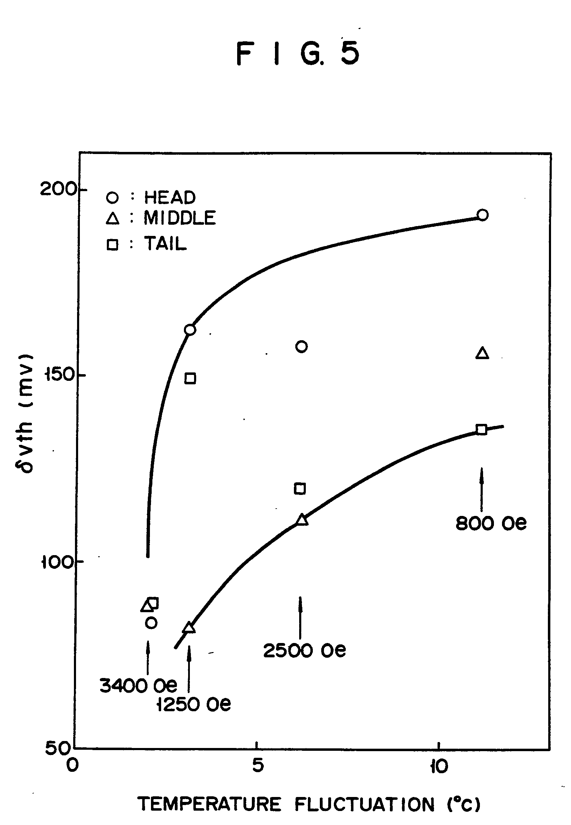

The present inventors produced micropatterned FETs such that a silicon circuit pattern was formed on a wafer, prepared from the above GaAs single crystal ingot, using an ion-implantation method at an acceleration voltage of 150 eV and a dose of $2.5 \times 10^{12}$ cm$^{-2}$. Fig. 5 is a graph showing the relationship between threshold voltage dispersion δVth and temperature fluctuation in the melt during the single crystal growth. As can be seen from Fig. 5, when the horizontal magnetic field applied to the GaAs melt was controlled to fall in second range R2 (with reference to 1,250 Oe as a target level) in the conventional method, dispersion δVth at head, middle and tail portions of the single crystal substrate varied widely. For example, dispersions δVth at head and tail portions are very large (i.e., exceeding 150 mV). This causes crystallinity of the single crystal substrate to be degraded, resulting in degradation in characteristics of highly integrated ICs. In contrast to this, when the magnetic field strength was set at 3,000 Oe or higher (e.g., 3,400 to 3,500 Oe) according to the concept of the present invention, temperature fluctuation in the melt was suppressed significantly (i.e., suppressed better than that in the case where the magnetic field strength was set at 1,250 Oe in second region R2). As a result, dispersions δVth at the head, middle, and tail portions of the substrate were minimized and substantially coincide with each other. This is the best evidence showing that the single crystal obtained in the method of the present invention has the most improved crystallinity.

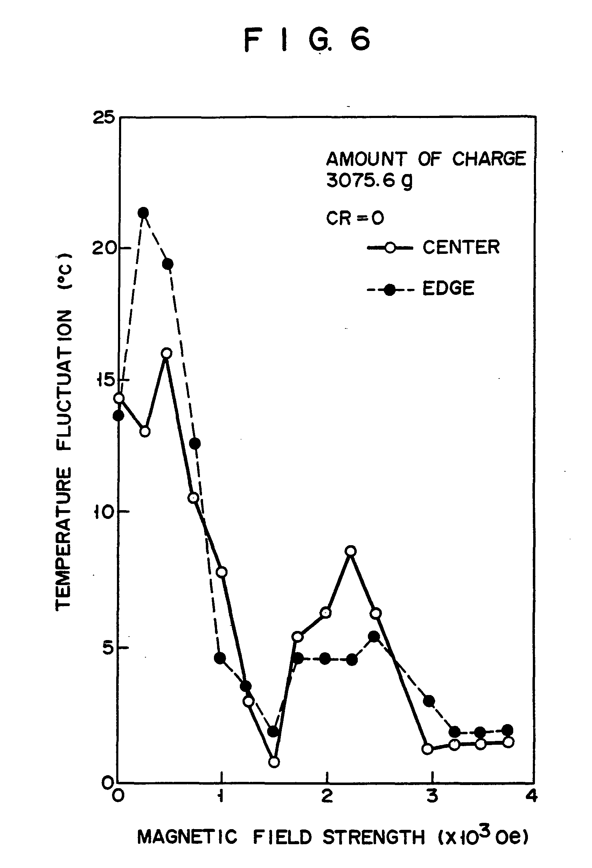

Fig. 6 is a graph showing the results of an additional test for demonstrating a change in temperature fluctuation occurring in the melt when the magnetic field strength was changed. A line connecting hollow circles indicates temperature fluctuation in the central surface portion of melt 18 placed in crucible 14. A line connecting black circles indicates temperature fluctuation in the peripheral surface portion of the melt. The graph also reveals that the temperature fluctuation in the melt can be satisfactorily suppressed when the magnetic field strength is set at 3,000 Oe or higher, according to the concept of the present invention.

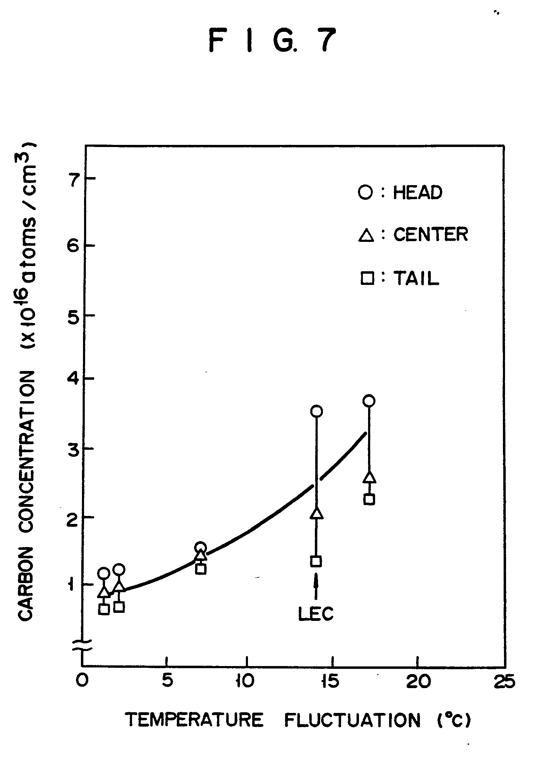

Fig. 7 is a graph showing, based on the results of measurement, the relationship between temperature fluctuation in the melt and a carbon concentration in a wafer of GaAs single crystal grown in accordance with the technique of the present invention. In this measurement, a conventional PBN crucible was used. This graph shows that the carbon concentration of the single crystal manufactured decreased as the temperature fluctuation decreased. In other words, when temperature fluctuation was suppressed by a horizontal magnetic field having a strength corresponding to fourth range R4 (Fig. 1B), during the manufacture of the single crystal in accordance with the concept of the present invention, the carbon concentration of the resultant single crystal was decreased, thus improving uniformity of the single crystal. In Fig. 7, the data indicated by "LEC" indicates the carbon concentration of the head, middle, and tail portions of the single crystal wafer when the conventional LEC method was used. It has already been demonstrated from the graph in Fig. 6 that the temperature fluctuation in the melt can be suppressed to about 2°C according to the present invention. In addition, as can be understood from Fig. 7, the carbon concentration of the single crystal can be improved to about $1 \times 10^{16}$ atoms/cm$^3$ with the concept of the present invention.

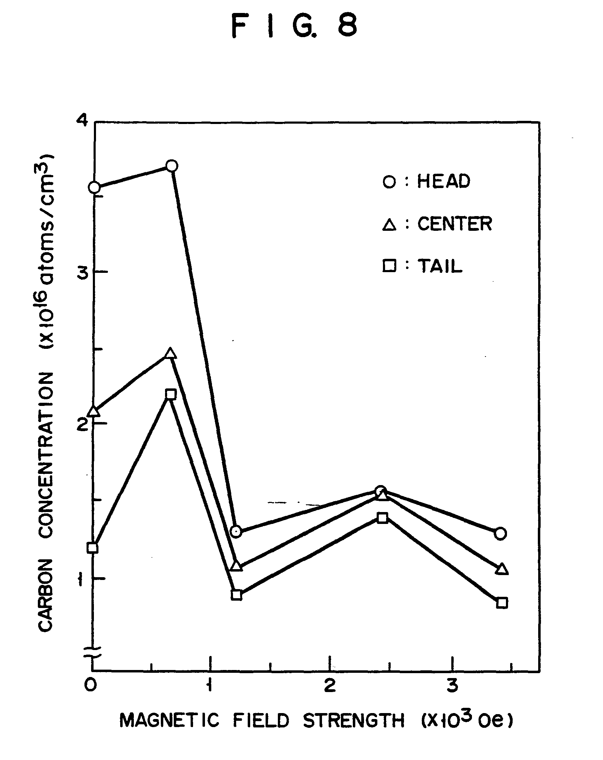

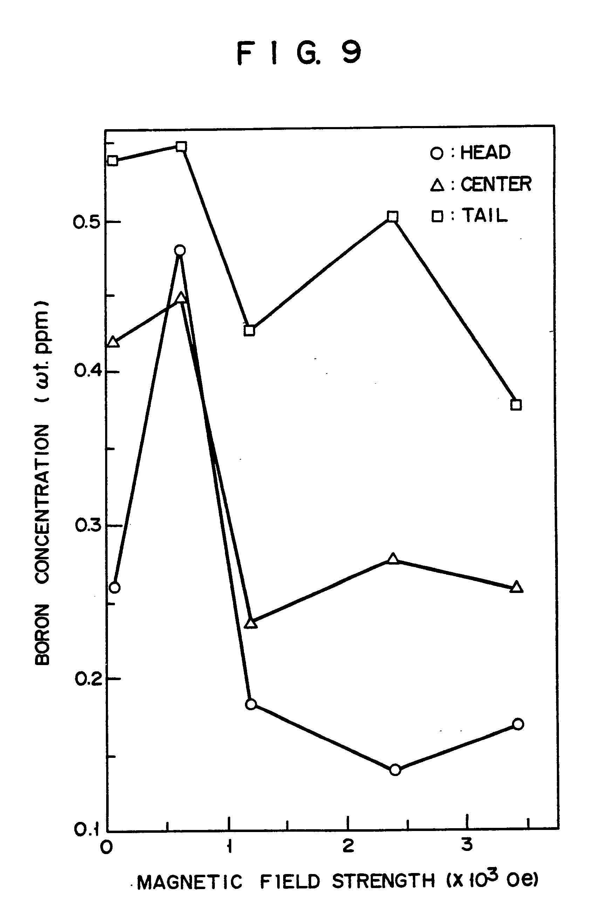

Fig. 8 is a graph showing a change in carbon concentration in the single crystal with respect to the magnetic field strength applied to the melt. As can be seen therein, when the strong horizontal magnetic field (e.g., of 3,000 Oe or higher) is applied to the melt, the carbon concentration in the single crystal is effectively decreased. Fig. 9 similarly shows a change in boron concentration in the single crystal. In Fig. 9, when the magnetic field strength is set at 3,000 Oe or higher, the boron concentration in the single crystal can also be effectively decreased.

As has been fully understood from the above descriptions, a single crystal with high purity and uniformity can be produced when the single crystal is pulled while a horizontal magnetic field having a strength of 3,000 Oe or higher (preferably corresponding to fourth range R4) is applied to the melt. Unlike the conventional method wherein a single crystal is pulled while a horizontal magnetic field having a strength corresponding to second range R2 (Fig. 1B) is applied to the melt, since single crystal growth conditions (specifically, setting precision of the magnetic field strength) need not be so precise, single-crystal manufacturers can easily carry out the pulling method of the present invention.

According to the present invention, since temperature fluctuation in the melt can be effectively suppressed or prevented, deviation at a solidified interface of the melt during the single-crystal pulling process can also be suppressed, thus flattening a meniscus pattern of the single crystal. Therefore, an improvement in signal-to-noise ratio of the detection signal from a weight detector arranged in the apparatus can be expected. It was confirmed in the test of the present inventors that the improvement in meniscus pattern could double the signal-to-noise ratio of the single-crystal weight detection signal when compared to the conventional apparatus. This increases a gain of a control system for controlling a diameter of the ingot-like single crystal, resulting in improved precision of the control system. This also contributes an improved yield of single crystal manufacture.

Furthermore, since crucible receptacle 16 and heat shielding members 24a to 24c comprise AlN, the melt can be prevented from being contaminated by oxides during the single crystal growth, unlike conventional apparatus parts comprising carbon. This improves the quality of the resultant single crystal. Since the number of carbon parts in the apparatus can be decreased, oxygen and/or hydrogen content in the high-pressure sealed atmosphere can be decreased considerably. As a result, in addition to the above advantages, heat characteristics of the heater can be improved, thus prolonging its life.

It should be noted that heater 22 for heating melt 18 is driven not by AC voltage but by DC voltage, thus preventing heating elements constituting heater 22 from being mechanically vibrated during heating the melt. In the conventional apparatus, since the heater is AC driven, an electromagnetic force is generated in accordance with a change in AC current flowing through the heating elements, thereby heavily vibrating the heating elements. In particular, in the method of the present invention, since the strong horizontal magnetic field having a strength of at least 3,000 Oe is applied to the melt during the single crystal growth as above, this problem becomes more serious if the heater is AC driven. If the heating elements are heavily vibrated, carbon, gas-containing carbon components, or carbon powder contained in the heating elements can be dispersed in the high-pressure atmosphere in housing 12, contaminating the melt in crucible 14. If an impurity concentration in the melt (e.g., carbon, boron, and the like) is increased, the single crystal quality is impaired. However, when the heater is DC driven, the above problems can easily be overcome. As a result, single crystal productivity can be improved in addition to improved uniformity based on the LEC method.

Another example of a GaAs single crystal produced in accordance with the concept of the present invention will now be described. About 3 kg of GaAs melt was prepared in PBN crucible 14, with an inner diameter of 150 mm, as follows. The temperature in crucible 14 was increased in one hour to 600°C, at which liquid encapsulant 20 was sufficiently softened. The temperature was kept unchanged for 30 minutes so that the material in crucible 14 was completely covered with liquid encapsulant 20. When the temperature was increased to 800°C in 5 minutes, As melted and began reacting with Ga. The temperature was then increased to 1,200°C in 5 minutes, thus obtaining GaAs melt 18. In this case, the pressure in housing 12 was increased to about 70 atm. Subsequently, the pressure in housing 12 was set at 20 atom, and the seeding process was performed. After 2,700 g of <100> single crystal having a diameter of 85 mm was grown, the temperature was decreased to ambient temperature at a rage of −200°C/h. A current flowing through heater 22 during the single crystal growth was set at about 600 A. A DC power supply was used, and a single crystal was manufactured without any problems.

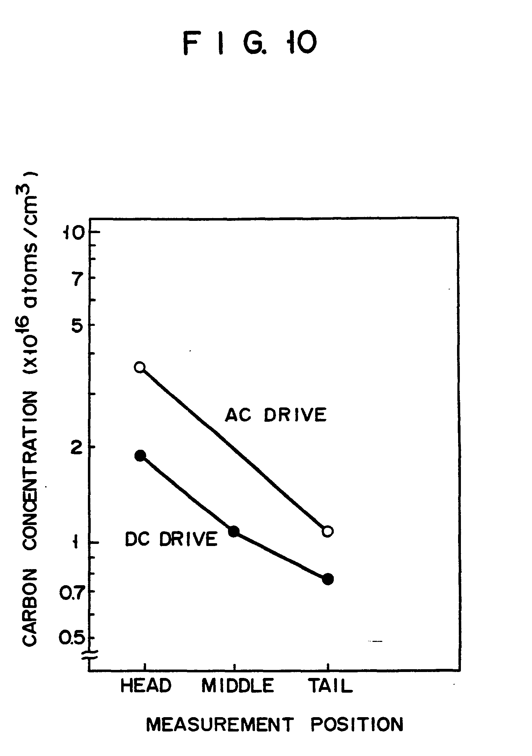

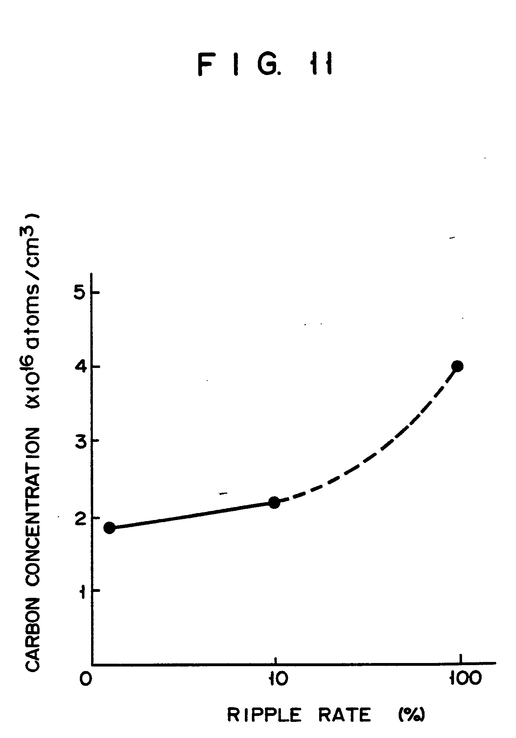

The carbon concentration at the head, middle, and tail portions of the resultant single crystal was then measured by an ultraviolet ray absorption method. Fig. 10 is a graph comparing the carbon concentrations of single crystals using the DC power supply with a ripple rate of 1% or less and a normal AC power supply, respectively. As is apparent from Fig. 10, when the DC power supply was used, the carbon concentration in the single crystal could be reduced to half that of the conventional apparatus. Fig. 11 shows a change in carbon concentration when a capacitance of a capacitor of the DC power supply was varied and the ripple rate was changed. From Fig. 11, the smaller the ripple rate, the lower the carbon concentration. Therefore, if the ripple rate is 10% or less, the carbon concentration can be significantly reduced.

According to this embodiment, when DC power supply 52 is used for heater 22, the carbon concentration in the GaAs single crystal can be reduced (1/2 that of the conventional method), thus allowing the manufacture of high-quality GaAs single crystals. Since unstable factors causing an increase in carbon concentration are eliminated, the carbon concentration in GaAs is stabilized, and reproducibility is improved. If the power supply of the conventional apparatus is replaced, the method of the present invention can be easily carried out.

It was found that the carbon concentration in a single crystal portion, without causing a change in resistivity ($\Delta\rho$) before and after the heating process, could be reduced below $5 \times 10^{15}$ cm$^{-3}$ when AlN was used for the heat shielding members as in this embodiment. In other words, if AlN is used, a GaAs single crystal having a carbon concentration below $5 \times 10^{15}$ cm$^{-3}$ can be obtained.

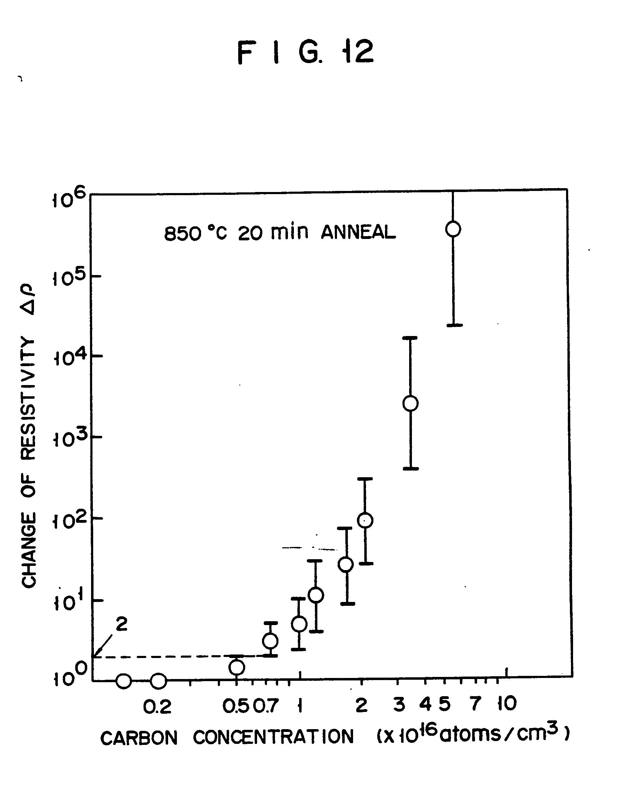

In addition, it was experimentally confirmed that a change in resistivity before and after the heating process was reduced considerably when AlN is used for the heat shielding members. This means that the carbon concentration is low, as can be seen from Fig. 12. Therefore, when AlN was used for the heat shielding members, the carbon concentration in the GaAs single crystal can be reduced significantly.

Although the present invention has been shown and described with reference to particular embodiments, various changes and modifications which are obvious to a person skilled in the art to which the invention pertains are deemed to lie within the scope of the invention.

For example, the magnetic field strength is not limited to 3,400 to 3,500 Oe, but can fall within the range corresponding to fourth range R4. A single crystal to be grown is not limited to GaAs, but can be III—V semiconductors (e.g., InP, GaP, GaSb, and the like) or monoatomic crystals (e.g., Si, Ge, and the like). However, since the magnetic field strength in fourth range R4 changes depending on the type of single crystals to be grown, fourth range R4 must be adjusted to correspond therewith. Furthermore, the technique of the present invention can be applied to any method for pulling a single crystal from a melt, in addition to the LEC method described previously. The heater is not limited to that shown in Fig. 2, but can consist of a plurality of heating elements containing carbon components.

## Claims

1. A method of manufacturing a semiconductive single crystal by a pulling method, comprising applying DC electric power to a heater (22) to heat an envelope (14) containing a III—V semiconductor material (18), thereby obtaining a semiconductive melt (18) in said envelope (14);

applying a horizontal magnetic field to said melt (18);

placing a seed crystal (36) into contact with said melt (18) and pulling said seed crystal (36), thus growing a single crystal (38),

characterised in that the magnetic field is set in a fourth highest strength region R4, which region R4 is defined by dividing the magnetic field, when increased with respect to temperature fluctuations occurring in said melt, into sub-regions including a first region R1 representing the lowest strength region, a second region R2 in which the temperature fluctuation is suppressed, a third region R3 in which the temperature fluctuation tends to increase, and the fourth region R4 in which the temperature fluctuation is again suppressed.

2. The method according to claim 1, characterized in that the horizontal magnetic field has a strength of not less than 3,000 Oe.

3. The method according to claim 1, characterized in that said horizontal magnetic field has a strength of approximately 3,500 Oersteds and said melt (18) comprises gallium arsenide.

## Patentansprüche

1. Verfahren zur Herstellung eines halbleitenden Einkristalls nach der Ziehmethode durch Anlegen einer Gleichspannung an eine Heizvorrichtung (22) zur Erwärmung eines Gefäßes (14) mit einem III—V Halbleitermaterial (18), wobei in dem Gefäß (14) eine Halbleitermaterialschmelze (18) erhalten wird;

Anlegen eines horizontalen Magnetfeldes an die Schmelze (18);

Inberührungbringen eines Keimkristalls (36) mit der Schmelze (18) und Ziehen des Keimkristalls (36), wobei ein Einkristall (38) wächst,

dadurch gekennzeichnet, daß das Magnetfeld in einem Bereich R4 der vierthöchsten Stärke, der durch Unterteilen des Magnetfeldes bei einer Erhöhung entsprechend in der Schmelze auftretenden Temperaturschwankungen in Unterbereiche, einschließlich eines ersten Bereichs R1 der geringsten Stärke, eines zweiten Bereichs R2, in dem die Temperaturschwankung unterdrückt wird, eines dritten Bereichs R3, in dem die Temperaturschwankung stärker wird, und den vierten Bereich R4, in dem die Temperaturschwankung erneut unterdrückt wird, definiert ist, angelegt ist.

2. Verfahren nach Anspruch 1, dadurch gekennzeichnet, daß das horizontale Magnetfeld eine Stärke von nicht weniger als 3,000 Oe aufweist.

3. Verfahren nach Anspruch 1, dadurch gekennzeichnet, daß das horizontale Magnetfeld eine Stärke von etwa 3,500 Oersted aufweist und die Schmelze (18) Galliumarsenid umfaßt.

**Revendications**

1. Procédé de fabrication d'un monocristal semiconducteur par un procédé de tirage, comprenant les opérations suivantes:

appliquer une puissance électrique continue à un élément chauffant (22) afin de chauffer une enceinte (14) contenant un matériau semiconducteur III—V (18), de manière à obtenir un bain fondu de semiconducteur (18) dans ladite enceinte (14);

appliquer audit bain fondu (18) un champ magnétique horizontal;

placer un germe cristallin (36) en contact avec ledit bain fondu (18) et tirer ledit germe cristallin (36), de manière à faire croître un monocristal (38),

caractérisé en ce que le champ magnétique est positionné dans une quatrième région, d'intensité la plus élevée, R4, laquelle région R4 est définie par subdivision du champ magnétique, lorsque celui-ci augmente en relation avec des fluctuations de température se produisant dans ledit bain fondu, en des sous-régions comportant une première région R1, qui représente la région d'intensité la plus faible, une deuxième région R2, dans laquelle la fluctuation de température est supprimée, une troisième région R3, dans laquelle la fluctuation de température tend à augmenter, et la quatrième région R4, dans laquelle la fluctuation de température est de nouveau supprimée.

2. Procédé selon la revendication 1, caractérisé en ce que le champ magnétique horizontal possède une intensité qui n'est pas inférieure à 3,000 Oe.

3. Procédé selon la revendication 1, caractérisé en ce que ledit champ magnétique horizontal possède une intensité d'environ 3,500 Oe, et ledit bain fondu (18) consiste en arséniure de gallium.

F I G. 1A

F I G. 1B

F I G. 2

# F I G. 3

EP 0 194 051 B1

F I G. 4A

F I G. 4B

# F I G. 5

# F I G. 6

EP 0 194 051 B1

F I G. 7

8

# F I G. 8

# F I G. 9

F I G. 10

# F I G. 11

EP 0 194 051 B1

F I G. 12

13